# EUROPÄISCHE PATENTANMELDUNG

(11) **EP 1 202 347 A2**
(43) Veröffentlichungstag der Anmeldung: **02.05.2002**
(21) Anmeldenummer: 01124731.9
(22) Anmeldetag: 17.10.2001
(51) Int. Cl.: H01L 23/495, H01L 23/48

(54) **Verfahren zur Herstellung eines Metallträgerrahmens, Metallträgerrahmen und seine Verwendung**

(30) Priorität: 31.10.2000 DE 10054081
(71) Anmelder: W.C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzei, Günter, 63791 Karlstein (DE)
(74) Vertreter: Kühn, Hans-Christian

(57) **Zusammenfassung**

Es wird u. a. ein Metallträgerrahmen bereitgestellt, mit mindestens einer Vertiefung (2) im Bereich einer Kontaktfläche (5) der Oberfläche (3), der dadurch gekennzeichnet ist, dass die mindestens eine Vertiefung (2) an ihrem der Oberfläche (3) zugewandten Ende einen maximalen Querschnitt aufweist, dass die mindestens eine Vertiefung (2) rings um ihren maximalen Querschnitt einen parallel zur Oberfläche (3) des Metallträgerrahmens (1) ausgerichteten, ringförmigen Rückhaltefalz (4) aufweist, dass die Seite (4a) des Rückhaltefalzes (4), die der Vertiefung (2) abgewandt ist, eben mit der Oberfläche (3) des Metallträgerrahmens (1) abschließt und dass der ringförmige Rückhaltefalz (4) einstückig mit dem Metallträgerrahmen (1) verbunden ist.

## Beschreibung

Die Erfindung betrifft einen Metallträgerrahmen, seine Verwendung sowie ein Verfahren zur Herstellung des Metallträgerrahmens.

In DE 198 52 832 A1 wird ein Leiterrahmen offenbart, bei dem eine Metallfolie mindestens eine Vertiefung im Randbereich der Kontaktfläche und/oder mindestens eine Vertiefung im Bereich der späteren Laminierung aufweist. Diese Vertiefungen können bauelementspezifisch angebracht werden und die ansonsten anzubringenden Lotkugeln ersetzen. Weiterhin können die Metallfolien mindestens eine Vertiefung im Randbereich der Kontaktfläche und/oder mindestens eine Vertiefung im Bereich der späteren Laminierung aufweisen, da beim Zusammenpressen der Metallfolie mit der Kunststofffolie sich eventuell überflüssiges Klebstoffmaterial in den Vertiefungen, insbesondere in den Rillen, sammeln kann und somit ein Verschmutzen der mit anderen Bauelementen zu verbindenden Stellen der Metallfolie wirkungsvoll verhindert wird. Nachteilig bei dieser Ausführungsform ist jedoch die Tatsache, dass in Einzelfällen die Verbesserung der Haftfähigkeit nicht ausreichend ist, so dass es zu einzelnen Ablösungen zwischen Chip und Leiterrahmen kommen kann.

Die DE 198 60 716 C1 offenbart eine Verbindungsanordnung mit einer Leiterplatte aus Epoxidharz. Auf der Leiterplatte befinden sich Anschlußkontaktflächen, sogenannte Pads, die über einen elektrisch leitfähigen Klebstoff elektrisch und mechanisch mit einem elektronischen Bauteil verbunden werden. Um den mechanischen Kontakt zu verbessern, sind die Pads nicht vollflächig ausgeführt sondern mit Ausnehmungen versehen, in welche der leitfähige Klebstoff fließen und sich beim Aushärten dort verankern kann. Damit benetzt der Klebstoff nicht nur das Pad, sondern auch die Leiterplatte selbst. Um den mechanischen Kontakt zwischen Pad und elektronischem Bauteil weiter zu verbessern, werden die Seitenflächen der Pads angeätzt, so dass eine Hinterschneidung erzeugt wird, die den ausgehärteten Klebstoff zurückhalten kann. Nachteilig ist bei diesem Verfahren, dass die Leiterplatte selbst nicht leitfähig ist und damit zusätzlich leitfähige Pads aufgebracht werden müssen. Damit ist auch die Haftung der Pads an der Leiterplatte eine entscheidende Größe für die Haltbarkeit der Verbindung insgesamt. Zudem ist das Anätzen der Seitenflächen der Pads ein aufwendiger und schwieriger Verfahrensschritt, nachdem solche Pads üblicherweise nur wenige µm Schichtdicke besitzen.

Die DE 44 38 449 A1 behandelt unter anderem ein Verfahren zur direkten Kontaktierung elektronischer Bauelemente mit einem Träger. Dabei kommen ein Träger mit ebener Oberfläche und elektronische Bauteile mit Einkerbungen zum Einsatz, wobei in den Einkerbungen die Kontaktflächen des Bauelements angeordnet sind. Die elektrische und mechanische Verbindung zwischen Träger und Bauelement erfolgt mittels eines Lotes, das aufgrund von Kapillarkräften in die Einkerbungen des Bauelementes gesaugt wird.

Bei diesem Verfahren erweist sich die notwendige mechanische Bearbeitung der elektronischen Bauteile als nachteilig, nachdem es sich hier meist um empfindliche und diffizile Teile handelt. Zudem ist der Kontakt zwischen Träger und Lot nicht verbessert worden.

Die deutsche Auslegeschrift Nr. 1 288 177 offenbart ein Verfahren zur Herstellung einer elektrischen und mechanischen Verbindung zwischen flächig aufeinander aufliegenden metallischen Kontakten mittels Kleben mit einem nichtleitenden Klebstoff. Dabei wird die Oberfläche mindestens eines Kontakts aufgerauht und mit dem Kleber versehen, anschließend der andere Kontakt auf den Kleber aufgesetzt und beide Kontakte aneinandergepreßt, bis die Spitzen der aufgerauhten Kontaktfläche, die aufgrund der Aufrauhung über die ursprüngliche Oberfläche des einen Kontakts hinausragen, eine elektrische Verbindung mit dem anderen Kontakt geben. Dabei wird der nichtleitende Kleber in die Vertiefung der Aufrauhung abgedrängt. Für die Verbindung eines empfindlichen elektronischen Bauteils mit einem Träger ist dieses Verfahren aufgrund der hohen Kräfte, die auf die beiden Teile ausgeübt werden müssen, nicht geeignet.

Aus dem Vorgenannten ergibt sich das Problem, mit Hilfe eines neuen Metallträgerrahmens, seiner Verwendung und mit Hilfe eines neuartigen Verfahrens zur Herstellung des Metallträgerrahmens die oben genannten Nachteile zumindest teilweise zu beseitigen. Insbesondere soll ein kostengünstig und einfach herstellbarer Metallträgerrahmen bereitgestellt werden, mit dessen Hilfe es möglich ist, eine hohe Haftfestigkeit zwischen elektronischen Bauteilen und dem Leiterrahmen zu gewährleisten.

Dieses Problem wird erfindungsgemäß durch einen Metallträgerrahmen nach Anspruch 1, eine Verwendung eines Metallträgerrahmens nach Anspruch 5, und ein Verfahren zur Herstellung des Metallträgerrahmens nach Anspruch 6 gelöst.

Der erfindungsgemäße Metallträgerrahmen mit mindestens einer Vertiefung in seiner Oberfläche im Bereich einer Kontaktfläche ist so gestaltet, dass die mindestens eine Vertiefung an ihrem der Oberfläche zugewandten Ende einen maximalen Querschnitt aufweist, dass die mindestens eine Vertiefung rings um ihren maximalen Querschnitt einen parallel zur Oberfläche des Metallträgerrahmens ausgerichteten, ringförmigen Rückhaltefalz aufweist, dass die Seite des Rückhaltefalzes, die der Vertiefung abgewandt ist, eben mit der Oberfläche des Metallträgerrahmens abschließt und dass der ringförmige Rückhaltefalz einstückig mit dem Metallträgerrahmen verbunden ist.

Diese spezifische Ausgestaltung der Oberfläche wird mittels des erfindungsgemäßen Verfahrens realisiert. Bei diesem werden folgende Schritte ausgeführt:
- Einprägen mindestens einer Vertiefung in die Oberfläche des Metallträgerrahmens an mindestens einer Kontaktfläche unter Ausbildung eines Wulstes auf der Oberfläche rings um die Vertiefung, wobei der Wulst aus Material des Metallträgerrahmens gebildet wird, das aus der Vertiefung verdrängt wird;
- Aufsetzen eines Stempels auf den Wulst, wobei die Fläche des Stempels, die auf den Wulst aufsetzt, planparallel zur Oberfläche des Metallträgerrahmens ausgebildet ist;
- Aufbringen eines Druckes senkrecht zur Oberfläche auf den Wulst mittels des Stempels und planieren der Oberfläche unter Ausbildung des ringförmigen Rückhaltefalzes aus dem Material des Wulstes.

Dieser Falz bildet - im Querschnitt gesehen - an der Oberfläche quasi bezüglich der Vertiefung einen Materialvorsprung, der eine Verengung der Vertiefungsöffnung und somit eine hintergreifende Funktion bei Ausfüllen mittels Klebstoff bzw. Lot ausbildet. Auf diese Art und Weise wird die Haftfestigkeit indirekt über das fixierte Klebstoff- bzw. Lotmaterial zwischen den einzelnen Bauelementen und dem Metallträgerrahmen bzw. einem Leiterrahmen (Verbund aus einem Metallträgerrahmen-Kunststoff-Laminat) wesentlich erhöht.

In der Praxis hat es sich bewährt, dass die Vertiefung kegelförmig ausgebildet ist, wobei die Grundfläche des Kegels dem maximalen Querschnitt entspricht.

Weiterhin hat es sich bewährt, wenn die Vertiefung in Form einer Pyramide mit quadratischer Grundfläche ausgebildet ist, wobei die quadratische Grundfläche der Pyramide dem maximalen Querschnitt entspricht.

Weiterhin hat es sich in der Praxis in vorteilhafter Weise bewährt, dass die Vertiefung eine lotrechte Maximaltiefe von 5 bis 200 µm aufweist.

Der erfindungsgemäße Metallträgerrahmen kann als Halbleiterträger, IC-Gehäuseteil, Schleifer, Bürste, Verbinder oder als Sensor dienen.

Aus dem erfindungsgemäßen Kontext ist zu erkennen, dass die Verwendung von mindestens einer Vertiefung an mindestens einer Kontaktfläche der Oberfläche eines Metallträgerrahmens, insbesondere eines erfindungsgemäßen Metallträgerrahmens, zur Erhöhung der Adhäsionswirkung bei späterer Kontaktierung von entscheidender Bedeutung ist. Dies gilt sowohl für spätere Kunststoff-Laminierungen mit Klebstoff oder bei der Fixierung von Bauteilen mittels Klebstoff oder Lot.

Die nachfolgenden Beispiele dienen zur Erläuterung der Erfindung.

Es zeigen:
- Figur 1: eine skizzenhafte Darstellung eines Ausschnittes eines erfindungsgemäßen Metallträgerrahmens im Querschnitt;
- Figur 2: eine skizzenhafte Darstellung einer Vertiefung mit entsprechendem Rückhaltefalz im Querschnitt;
- Figur 3: eine skizzenhafte Darstellung eines Ausschnittes eines weiteren erfindungsgemäßen Metallträgerrahmens im Querschnitt;
- Figur 4: eine skizzenhafte Darstellung des in Figur 3 gezeigten Metallträgerrahmens in Aufsicht;
- Figur 5: eine Darstellung eines mit einem Chip verbundenen Metallträgerrahmens.
- Figuren 6 bis 11: zeigen einen Verfahrensablauf zur Herstellung eines erfindungsgemäßen Metallträgerrahmens

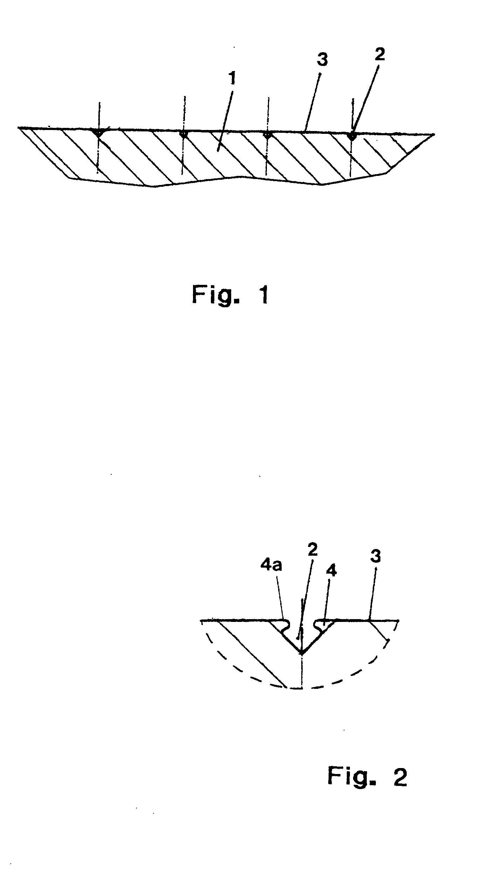

In Figur 1 ist im Querschnitt ein Ausschnitt eines Metallträgerrahmens 1 dargestellt. Dieser weist mehrere Vertiefungen 2 auf, wobei diese kegelförmig ausgestaltet sind.

In Figur 2 ist eine vergrößerte Darstellung einer einzelnen kegelförmigen Vertiefung 2 im Querschnitt abgebildet. Zwischen Vertiefung 2 und der Oberfläche 3 ist quasi den Hohlraum der Vertiefung verkleinernd ein rundlaufender Rückhaltefalz 4 angeordnet, wobei die Seite des Rückhaltefalzes 4a, die der Vertiefung 2 abgewandt ist, eben mit der Oberfläche 3 abschließt.

Wird eine solche Vertiefung 2 mit Klebstoff bzw. Lot zur Verbindung eines Bauelementes mit dem Metallträgerrahmen gefüllt und ein Kontaktbein eines solchen Bauelementes entsprechend platziert, so tritt durch die hintergreifende Wirkung des Rückhaltefalzes 4 eine wesentliche Erhöhung der Haftfestigkeit zwischen Bauelement und Metallträgerrahmen 1 über den Kunststoff/das Lot und dem Metallträgerrahmen 1 auf.

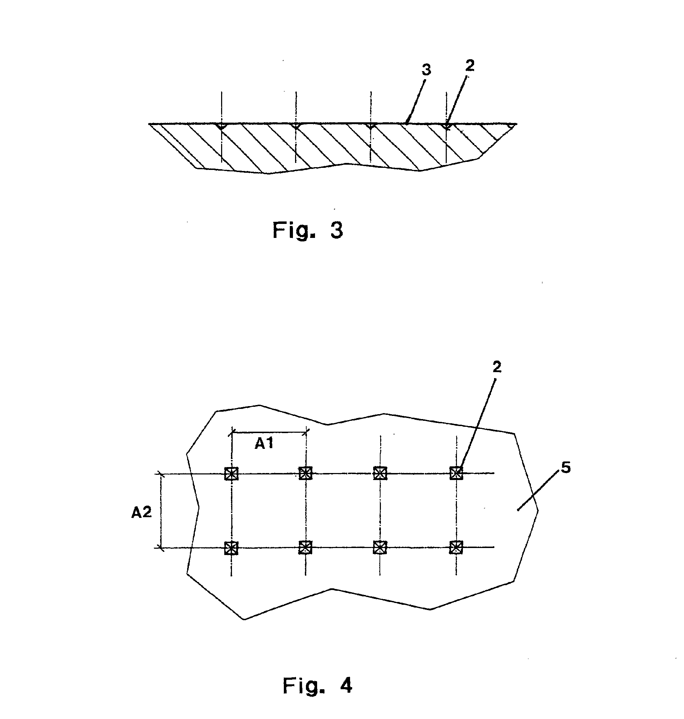

In Figur 3 ist im Querschnitt ein Ausschnitt eines weiteren erfindungsgemäßen Metallträgerrahmens 1 dargestellt. Dieser weist mehrere Vertiefungen 2 auf, wobei diese pyramidenförmig ohne Rückhaltefalze ausgestaltet sind.

Die einzelnen pyramidenförmigen Vertiefungen 2 sind auf einer entsprechenden Kontaktfläche 5 des Metallträgerrahmens 1 in einem gleichmäßigen Rechteckmuster angeordnet, wie in Figur 4 zu erkennen ist (A1 = 100 µm, A2 = 100 µm).

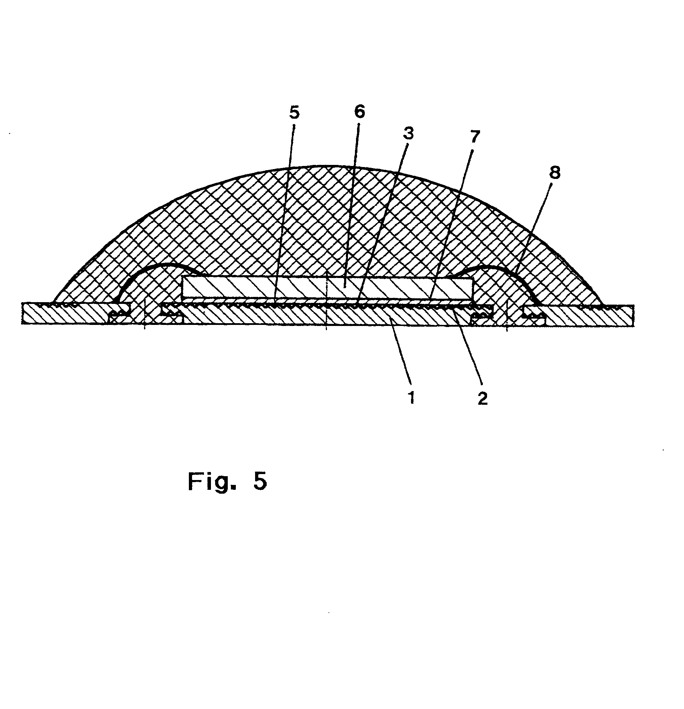

In Figur 5 ist ein Metallträgerrahmen 1 zu erkennen, der viele einzelne Vertiefungen 2 auf der einem Chip 6 zugewandten Seite aufweist. Der Chip 6 ist mittels eines Klebstoffes 7 am Metallträgerrahmen über die erhöhte Adhäsionsfähigkeit der profilierten Kontaktfläche 5 der Oberfläche 3 angeordnet. Der Chip 6 ist elektrisch über Bonddrähte 8 mit dem Metallträgerrahmen 1 verbunden. Der Chip 6 ist tropfenförmig in einer kunststoffartigen Vergussmasse schützend eingebettet.

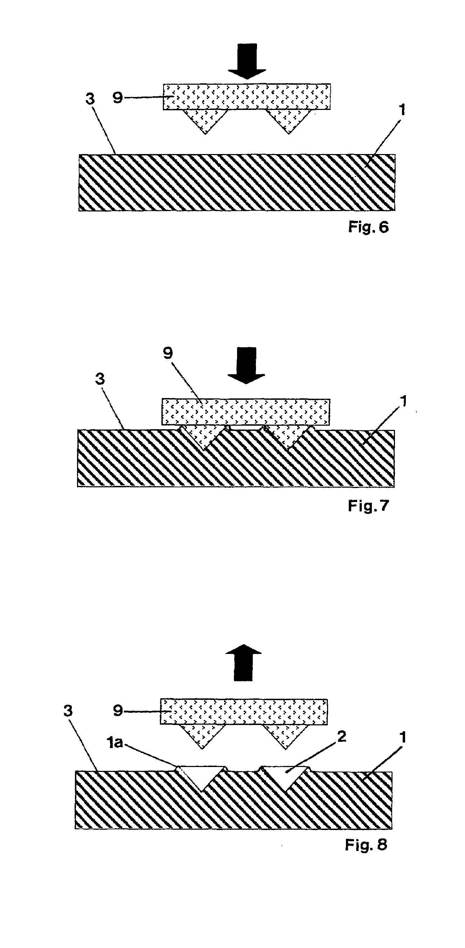

Figur 6 zeigt einen Metallträgerrahmen 1 und einen Stempel 9 mit Profil, der in Pfeilrichtung auf die Oberfläche 3 zubewegt wird.

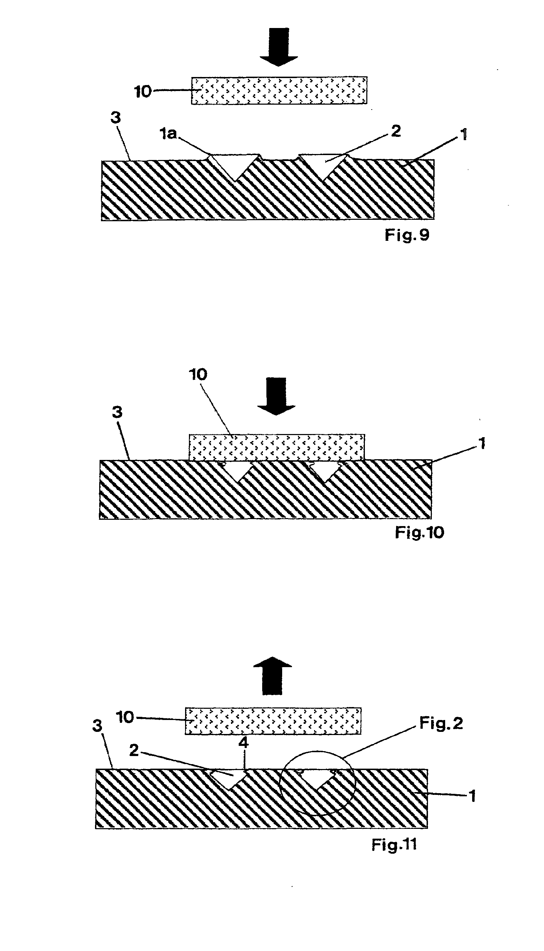

In Figur 7 ist dargestellt, wie der Stempel 9 mit seinem Profil in die Oberfläche 3 eindringt. Figur 8 zeigt die gebildten Vertiefungen 2 und den um die Vertiefungen 2 entstandenen Wulst 1a aus Material des Metallträgerrahmens 1.

Figur 9 zeigt den Metallträgerrahmen 1 und einen Stempel 10 mit planer Stempelfläche parallel zur Oberfläche 3, der in Pfeilrichtung auf die Oberfläche 3 zubewegt wird.

In Figur 10 ist dargestellt, wie der Stempel 10 auf die Oberfläche 3 aufsetzt und den Wulst 1a in die Vertiefung 2 zurückdrängt.

Figur 11 zeigt die gebildete Vertiefung 2 mit dem Rückhaltefalz 4 aus Material des Metallträgerrahmens 1. Eine vergrößerte Darstellung einer so gebildeten Vertiefung zeigt Fig. 2 im Detail.

## Patentansprüche

1. Metallträgerrahmen, mit mindestens einer Vertiefung (2) in seiner Oberfläche (3) im Bereich einer Kontaktfläche (5), **dadurch gekennzeichnet, dass** die mindestens eine Vertiefung (2) an ihrem der Oberfläche (3) zugewandten Ende einen maximalen Querschnitt aufweist, dass die mindestens eine Vertiefung (2) rings um ihren maximalen Querschnitt einen parallel zur Oberfläche (3) des Metallträgerrahmens (1) ausgerichteten, ringförmigen Rückhaltefalz (4) aufweist, dass die Seite (4a) des Rückhaltefalzes (4), die der Vertiefung (2) abgewandt ist, eben mit der Oberfläche (3) des Metallträgerrahmens (1) abschließt und dass der ringförmige Rückhaltefalz (4) einstückig mit dem Metallträgerrahmen (1) verbunden ist.

2. Metallträgerrahmen nach Anspruch 1, **dadurch gekennzeichnet, dass** die Vertiefung (2) kegelförmig ausgebildet ist, wobei die Grundfläche des Kegels dem maximalen Querschnitt entspricht.

3. Metallträgerrahmen nach Anspruch 1, **dadurch gekennzeichnet, dass** die Vertiefung (2) in Form einer Pyramide mit quadratischer Grundfläche ausgebildet ist, wobei die quadratische Grundfläche der Pyramide dem maximalen Querschnitt entspricht.

4. Metallträgerrahmen nach einem der Ansprüche 1 bis 3, **dadurch gekennzeichnet, dass** die Vertiefung (2) eine lotrechte Maximaltiefe im Bereich von 5 bis 200 µm aufweist.

5. Verwendung eines Metallträgerrahmens nach einem der Ansprüche 1 bis 4 als Halbleiterträger, IC-Gehäuseteil, Schleifer, Bürste, Verbinder oder Sensor.

6. Verfahren zur Herstellung eines Metallträgerrahmens (1) nach einem der Ansprüche 1 bis 4, insbesondere für elektronische Bauelemente, mit folgenden Schritten:
- Einprägen mindestens einer Vertiefung (2) in die Oberfläche (3) des Metallträgerrahmens (1) an mindestens einer Kontaktfläche (5) unter Ausbildung eines Wulstes (1a) auf der Oberfläche (3) rings um die Vertiefung (2), wobei der Wulst (1a) aus Material des Metallträgerrahmens (1) gebildet wird, das aus der Vertiefung (2) verdrängt wird;
- Aufsetzen eines Stempels (10) auf den Wulst (1a), wobei die Fläche des Stempels, die auf den Wulst (1a) aufsetzt, planparallel zur Oberfläche (3) des Metallträgerrahmens (1) aus gebildet ist; und
- Aufbringen eines Druckes senkrecht zur Oberfläche (3) auf den Wulst (1a) mittels des Stempels (10) und planieren der Oberfläche (3) unter Ausbildung des ringförmigen Rückhaltefalzes (4) aus dem Material des Wulstes (1a).
